# EUROPEAN PATENT SPECIFICATION

(11) **EP 4 382 933 B1**
(45) Date of publication and mention of the grant of the patent: **04.03.2026**
(21) Application number: 22920784.0
(22) Date of filing: 21.11.2022
(51) Int. Cl.: G01R 31/367, G01R 31/3842, G01R 31/392, G01R 19/00, G01R 31/396

(54) **BATTERY STATE ESTIMATION METHOD, AND BATTERY SYSTEM FOR PROVIDING METHOD**
VERFAHREN ZUR SCHÄTZUNG DES BATTERIEZUSTANDS UND BATTERIESYSTEM ZUR BEREITSTELLUNG DES VERFAHRENS
PROCÉDÉ D'ESTIMATION D'ÉTAT DE BATTERIE ET SYSTÈME DE BATTERIE POUR FOURNIR UN PROCÉDÉ

(30) Priority: 14.01.2022 KR 20220005739
(43) Date of publication of application: 12.06.2024
(73) Proprietor: LG Energy Solution, Ltd., Seoul 07335 (KR)
(72) Inventor: CHOI, Geon, Daejeon 34122 (KR); KIM, Dong Hyun, Daejeon 34122 (KR); HONG, Sung Ju, Daejeon 34122 (KR)
(74) Representative: Plasseraud IP
(86) International application number: PCT/KR2022/018435
(87) International publication number: WO 2023/136455

(56) References cited:
- DE-A1- 102015 101 160
- JP-A- 2019 144 211
- KR-A- 20110 111 018
- KR-A- 20180 043 048
- KR-A- 20180 101 823
- KR-A- 20190 019 316
- KR-B1- 101 717 001

## Description

### [Technical Field]

The present invention relates to a method for estimating (e.g., predicting) a state of a battery such as a state of charge (SOC), a state of health (SOH), a state of power (SOP), and the like that are hereinafter referred to as a state of x (SOX), and a battery system providing the same.

### [Background Art]

A battery mounted on a high output product such as an electric vehicle or a hybrid vehicle include a plurality of cells connected in series or parallel to supply a high voltage to a load. Since performance of the battery in an eco-friendly vehicle is directly related to performance of the vehicle, a role of a battery management system (hereinafter referred to as BMS) that efficiently manages a state of the battery is important.

The BMS estimates a state of charge (SOC), a state of health (SOH), a state of power (SOP), and the like of the battery (or a battery cell) based on a battery current flowing in the battery, a plurality of cell voltages of a plurality of battery cells, a battery temperature, and the like that are hereinafter referred to as battery data, and diagnoses the state of the battery based on the estimated result. When an error occurs as a result of diagnosing the state of the battery, the BMS may transmit the diagnosis result to an upper system (e.g., a vehicle, a bike, an ESS, or the like) equipped with a battery system to manage overall safety and performance of the upper system.

On the other hand, due to nonlinearity of the battery cell, it is impossible to directly measure the state of charge (SOC), the state of health (SOH), the state of power (SOP), and the like of the battery. Accordingly, the BMS includes an SOC estimation model, an SOH estimation model, and an SOP estimation model, and each estimation model estimates the state of charge (SOC), the state of health (SOH), and the state of power (SOP), and the like of the battery based on the battery data. An example of the state of charge (SOC) estimation can be found for instance in JP 2019 144211A which discloses estimating the charge condition based on weight corresponding to result of estimation parts.

However, since the battery is diagnosed based on a result obtained by an indirect estimation method rather than a direct measurement method, there is a problem in which it is difficult to trust the diagnosis result. In order to solve this problem, a method of estimating the state of charge (SOC) and the like by reflecting a weight to the plurality of estimation models has recently been used. However, since a uniformly determined weight is reflected in the estimation method without considering a type, a state, or the like of the upper system on which the battery system is mounted, a reliability problem of the estimation method is not fundamentally resolved.

### [Disclosure]

### [Technical Problem]

The present invention is to provide a battery state estimation method and a battery system providing the method that estimate a battery state (e.g., a state of charge (SOC), a state of health (SOH), a state of power (SOP), or the like) by reflecting a weight value optimized for an upper system equipped with the battery system in a plurality of estimation models.

### [Technical Solution]

The present invention provides battery systems as defined by independent claims 1 and 5 and a battery state estimation method as defined by independent claim 9. Preferred embodiments are defined in the appended dependent claims. The battery system according to one aspect of the present invention includes: a battery including a plurality of battery cells; a communication device that communicates with an upper system on which the battery system is mounted and receives identification information of the upper system, the identification information of the upper system identifies the upper system at which the battery system is mounted; a monitoring device that collects at least one of battery information including a plurality of cell voltages of the plurality of battery cells, a current of the battery, and a temperature of the battery; a storage device that stores a plurality of state of charge (SOC) estimation models estimating an SOC of each of the plurality of battery cells based on the battery information according to a predetermined algorithm and stores a previously set plurality of first weight values corresponding to the identification information of variety of upper systems; and a controller that determines first weight values from the stored plurality of first weight values based on the received identification information of the upper system, and calculates an average value of first SOCs by adding up results of applying the determined first weight values to a plurality of SOCs estimated by the plurality of SOC estimation models.

The controller may calculate an average value of second SOCs by adding up results of applying second weight values, corresponding to the identification information and a predetermined estimation condition, to the plurality of SOCs.

The estimation condition may be determined according to a result of comparing each of the cell voltages with a predetermined reference value.

The storage device may store a plurality of pieces of identification information of the upper system on which the battery system is mounted, the first weight values corresponding to each of the plurality of pieces of identification information, and the second weight values corresponding to each of the plurality of pieces of identification information.

The battery system according to another aspect of the present invention includes: a battery including a plurality of battery cells; a communication device that communicates with an upper system on which the battery system is mounted and receives identification information of the upper system, the identification information of the upper system identifies the upper system at which the battery system is mounted; a monitoring device that collects at least one of battery information including a plurality of cell voltages of the plurality of battery cells, a current of the battery, and a temperature of the battery; a storage device that stores a plurality of state of health (SOH) estimation models estimating an SOH of each of the plurality of battery cells based on the battery information according to a predetermined algorithm and stores a previously set plurality of first weight values corresponding to the identification information of variety of upper systems; and a controller that determines first weight values from the stored plurality of first weight values based on the received identification information of the upper system, and calculates an average value of first SOHs by adding up results of applying the determined first weight values to a plurality of SOHs estimated by the plurality of SOH estimation models.

The controller may calculate an average value of second SOHs by adding up results of applying second weight values, corresponding to the identification information, and a predetermined estimation condition to the plurality of SOHs.

The estimation condition may be determined according to a result of comparing each of the cell voltages with a predetermined reference value.

The storage device may store a plurality of pieces of identification information of the upper system on which the battery system is mounted, the first weight values corresponding to each of the plurality of pieces of identification information, and the second weight values corresponding to each of the plurality of pieces of identification information.

The battery state estimation method according to an aspect of the present invention includes: determining first weight values from a previously set plurality of first weight values based on identification information of an upper system on which a battery system is mounted the previously set plurality of first weight values corresponds to the identification information of variety of upper systems; receiving a plurality of states of charge (SOC) from a plurality of state of charge (SOC) estimation models estimating an SOC of each of the plurality of battery cells included in a battery based on battery information according to a predetermined algorithm; and calculating an average value of first SOCs by adding up results of applying the determined first weight values to the plurality of SOCs. The battery information includes at least one of a plurality of cell voltages of the plurality of battery cells, a current of the battery, and a temperature of the battery.

The determining of the first weight values may include determining second weight values corresponding to the identification information and a predetermined estimation condition, and the calculating of the average value may include calculating an average value of second SOCs by adding up results of applying the second weight values to the plurality of SOCs.

The estimation condition may be determined according to a result of comparing each of the cell voltages with a predetermined reference value.

### [Advantageous Effects]

The present invention may estimate a battery state by reflecting a weight value optimized for an environment in which a battery is used, which is an upper system at which a battery system is installed, in a plurality of estimation models so that it increases reliability of an estimated result of the battery state.

The present invention may estimate a battery state by reflecting a weight value considering not only the upper system at which the battery system is installed but also a current state (e.g., a cell voltage or the like) of the battery to a plurality of estimation models so that it remarkably increases reliability of an estimated result of the battery state.

### [Description of the Drawings]

FIG. 1 is a conceptual diagram illustrating an upper system on which a battery system according to an embodiment is mounted.
FIG. 2 is a block diagram illustrating the battery system of FIG. 1 in detail.
FIG. 3 is a block diagram illustrating a function of a controller (MCU) of FIG. 2 in detail.
FIG. 4 is a flowchart illustrating a battery state estimation method according to an embodiment.

### [Mode for Invention]

Hereinafter, embodiments disclosed in the present specification will be described in detail with reference to the accompanying drawings, and in the present specification, the same or similar constituent elements will be denoted by the same or similar reference numerals, and a redundant description thereof will be omitted. The terms "module" and/or "unit, portion, or part" representing constituent element used in the following description are used only in order to make understanding of the specification easier, and thus, these terms do not have meanings or roles that distinguish them from each other by themselves. In addition, in describing embodiments of the present specification, when it is determined that a detailed description of the well-known art associated with the present invention may obscure the gist of the present invention, it will be omitted.

Terms including ordinal numbers such as first, second, and the like will be used only to describe various constituent elements, and are not to be interpreted as limiting these constituent elements. The terms are only used to differentiate one constituent element from other constituent elements.

It is to be understood that when one constituent element is referred to as being "connected" or "coupled" to another constituent element, it may be connected or coupled directly to the other constituent element or may be connected or coupled to the other constituent element with a further constituent element intervening therebetween. In contrast, it should be understood that, when it is described that an element is "directly coupled" or "directly connected" to another element, no element is present between the element and the other element.

In the present application, it should be understood that the term "include", "comprise", "have", or "configure" indicates that a feature, a number, a step, an operation, a constituent element, a part, or a combination thereof described in the specification is present, but does not exclude a possibility of presence or addition of one or more other features, numbers, steps, operations, constituent elements, parts, or combinations, in advance.

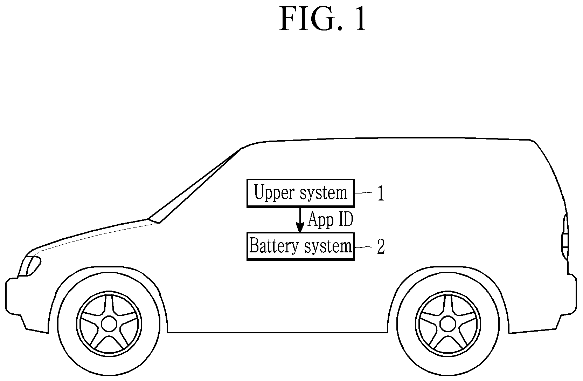

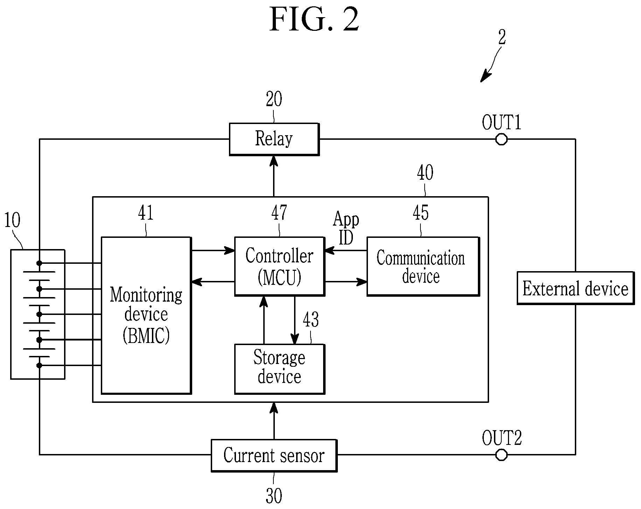

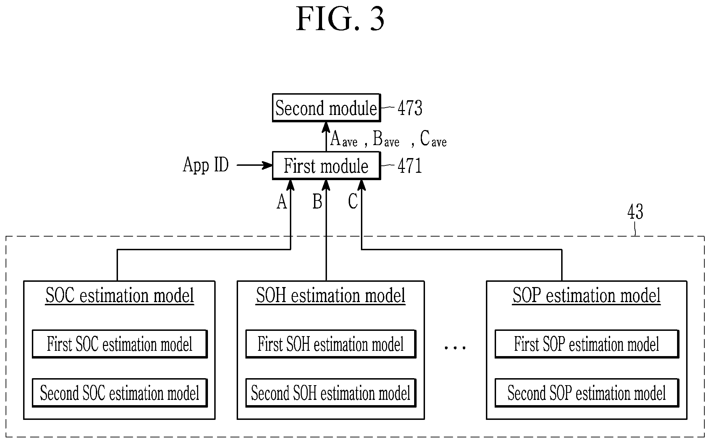

FIG. 1 is a conceptual diagram illustrating an upper system on which a battery system according to an embodiment is mounted, FIG. 2 is a block diagram illustrating a function of the battery system of FIG. 1 in detail, and FIG. 3 is a block diagram illustrating a function of a controller (MCU) of FIG. 2 in detail.

Referring to FIG. 1, the upper system 1 is a system on which the battery system 2 is mounted.

The upper system 1 may include all systems requiring a battery. For example, the upper system 1 may include a vehicle, a bike, an energy storage system (ESS), or the like.

The battery system 2 includes a customized state of x (SOX) estimation algorithm for the upper system 1. According to an embodiment, the battery system 2 identifies the upper system 1 at which the current battery system 2 is mounted, and estimates a state (a state of x (SOX)) of the battery corresponding to the identified upper system according to the SOX estimation algorithm.

Then, even when a standard battery usable in various upper systems 1 is positioned and used in a specific upper system 1, the battery system 2 may estimate a state of charge (SOC), a state of health (SOH), a state of power (SOP), and the like that well reflect a characteristic of an individual upper system 1. That is, the battery system 2 according to the embodiment may estimate a battery state (a state of x (SOX)) with high precision.

Referring to FIG. 2, the battery system 2 includes a battery 10, a relay 20, a current sensor 30, and a battery management system (BMS) 40.

The battery 10 may include a plurality of battery cells (Cell1-Celln) electrically connected in series or parallel. In an embodiment, the battery cell may be a rechargeable secondary battery. A predetermined number of battery cells may be connected in series to form a battery module, a predetermined number of battery modules may be connected in series to form a battery pack, and a predetermined number of battery packs may be connected in parallel to form a battery bank so that the battery bank supplies a desired power. Although FIG. 2 illustrates the battery 10 in which a plurality of battery cells (Cell1-Celln) are connected in series, the present invention is not limited thereto, and the battery 10 may be configured in a unit of the battery module, the battery pack, or the battery bank.

Each of the plurality of battery cells (Cell1-Celln) is electrically connected to the BMS 40 through wiring. The BMS 40 may collect and analyze various information on the battery cell that includes information on the battery cells (Cell1-Celln) so that the BMS controls charging, discharging, a protection operation, or the like of the battery cell, and an operation of the relay 20.

In FIG. 2, the battery 10 includes a plurality of battery cells (Cell1-Celln) connected in series, and is connected between two output terminals OUT1 and OUT2 of the battery system 2. The relay 20 is connected between a positive electrode of the battery system 2 and a first output terminal OUT1, and the current sensor 30 is connected between a negative electrode of the battery system 2 and a second output terminal OUT2. Components shown in FIG. 2 and a connection relationship between the components are embodiments, and the present invention is not limited thereto.

The relay 20 controls an electrical connection between the battery system 2 and an external device. When the relay 20 is turned on, the battery system 2 and the external device are electrically connected so that charging or discharging is performed, and when the relay 20 is turned off, the battery system 2 and the external device are electrically separated. In this case, the external device may be a charger that supplies power (or electric power) to the battery 10 to charge the battery 10 in a charging cycle, and may be a load to which the battery 10 discharges power in a discharging cycle.

The current sensor 30 is connected in series to a current path between the battery 10 and the external device. The current sensor 30 may measure a battery current flowing through the battery 10, and may transmit the measurement result to the BMS 40. For example, when the plurality of battery cells (Cell1-Celln) are connected in series, the battery current may correspond to a cell current. In this case, the battery current may be a charging current or a discharging current.

Although not shown in FIG. 2, the battery system 2 may further include a temperature sensor (not shown) for measuring a temperature of the battery 10. The temperature sensor may measure the temperature of the battery 10, and may transmit the measurement result to the BMS 40. A temperature of each of the plurality of battery cells (Cell1-Celln) may be estimated based on the temperature of the battery 10.

The BMS 40 includes a monitoring device (or a monitoring unit) 41, a storage device 43, a communication device 45, and a controller 47.

The monitoring device 41 is electrically connected to a positive electrode and a negative electrode of each of the plurality of battery cells (Cell1-Celln) so that it measures a cell voltage of each of the plurality of battery cells (Cell1-Celln). A value of the battery current measured by the current sensor 30 and a value of the temperature of the battery measured by the temperature sensor may be transmitted to the monitoring device 41. The monitoring device 41 transfers information on the measured cell voltage, the measured battery current, and the measured battery temperature to the controller 47. The monitoring device 41 can be a battery monitoring integrated circuit (BMIC), as known in the art.

For example, the monitoring device 41 may measure the cell voltage of each of the plurality of battery cells (Cell1-Celln) every predetermined period during a rest period in which charging and discharging does not occur, and may calculate the cell current based on the measured cell voltage. The monitoring device 41 may transmit the cell voltage and the cell current of each of the plurality of battery cells (Cell1-Celln) to the controller 47.

The storage device 43 stores system identification information APP ID, a weight value (or a weight), a plurality of estimation models for estimating the battery state (the state of x (SOX)), and battery information. The battery state (SOX) may include the state of charge (SOC), the state of health (SOH), the state of power (SOP), and the like of the battery cell. In this case, the battery information may include information related to the battery such as the cell voltage, the battery current, the battery temperature, and the like.

The storage device 43 (e.g., hardware-embedded memory) may store a plurality of SOC estimation models for estimating an SOC of each of the plurality of battery cells included in the battery 10 based on the battery information according to a predetermined algorithm (e.g., the SOX estimation algorithm). Although FIG. 3 illustrates a first SOC estimation model and a second SOC estimation model that is two SOC estimation models, the present invention is not limited thereto, and the BMS 40 may include three or more SOC estimation models.

For example, referring to FIG. 3, the storage device 43 may store the first SOC estimation model for estimating the state of charge (SOC) according to a conventionally well-known Coulomb counting method, the second SOC estimation model for estimating the state of charge (SOC) based on an open circuit voltage (OCV)-SOC relationship, a third SOC estimation model for estimating the state of charge (SOC) based on a terminal voltage, and the like.

The storage device 43 may store a plurality of SOH estimation models for estimating the state of health (SOH) of each of the plurality of battery cells included in the battery 10 based on the battery information according to a predetermined algorithm. Although FIG. 3 illustrates a first SOH estimation model and a second SOH estimation model that are two SOH estimation models, the present invention is not limited thereto, and the BMS 40 may include three or more SOH estimation models.

For example, referring to FIG. 3, the storage device 43 may store the first SOH estimation model for estimating the state of health (SOH) based on a conventionally well-known OCV-SOH relationship, the second SOH estimation model for estimating the state of health (SOH) based on an SOC-SOH relationship, a third SOH estimation model for estimating the state of health (SOH) based on a direct current internal resistance (DCIR) of the battery cell, and the like.

The storage device 43 may store a plurality of SOP estimation models for estimating the output state (SOP) of each of the plurality of battery cells included in the battery 10 based on the battery information according to a predetermined algorithm. Although FIG. 3 illustrates a first SOP estimation model and a second SOP estimation model that are two SOP estimation models, the present invention is not limited thereto, and the BMS 40 may include three or more SOP estimation models.

For example, referring to FIG. 3, the storage device 43 may store the first SOP estimation model for estimating the state of power (SOP) based on the direct current internal resistance (DCIR) that is conventionally well-known, the second SOP estimation model for estimating the state of power (SOP) based on an intersection between a discharging lower limit voltage and an I-V (current-voltage) profile calculated by a regression analysis method by using current data and voltage data, a third SOP estimation model for estimating the state of power (SOP) from the battery data using an adaptive calculation algorithm such as a Kalman filter, and the like.

The system identification information APP ID may be identification information for distinguishing the system at which the battery system 2 is mounted. For example, the storage device 43 may store various system identification information APP ID such as identification information (E_Vehicle and APP ID = 001) of a vehicle system, identification information (E_Bike and APP ID = 002) of a bike system, identification information (E_ESS and APP ID = 003) of the energy storage system (ESS), and the like.

The weight value may be a value that is previously set and then stored in the storage device 43 in order to estimate a customized battery state (SOX) for the upper system 1. According to an embodiment, the weight value may include a plurality of first weight values corresponding to the system identification information APP ID. According to another embodiment, the weight value may include a plurality of second weight values corresponding to the system identification information APP ID and a predetermined estimation condition. A more detailed description of the weight value will be given along with a description of the controller 47 below.

The estimation condition may be a condition reflecting a current state of the battery cell. For example, the estimation condition may be determined according to a result of comparing a cell voltage of the battery cell with a predetermined reference value. For another example, the estimation condition may include a condition determined by the cell voltage of the battery cell, the battery current, or the battery temperature. However, the estimation condition is not limited to the cell voltage, the battery current, and the battery temperature, and may include various conditions reflecting a current state of the battery 10 or the battery cell.

The communication device 45 communicates with the upper system 1, and receives identification information (hereinafter referred to as the system identification information) of the upper system 1. For example, the controller 47 may store the system identification information APP ID received by the communication device 45 in the storage device 43.

The controller 47 determines a weight value corresponding to at least one of the system identification information APP ID and the estimation condition received through the communication device 45, and estimates the battery state (SOX) based on the determined weight value.

Referring to FIG. 3, the controller 47 may include a first module 471 for estimating the state (SOX) of the battery 10 and a second module 473 for diagnosing the battery 10 according to a predetermined criterion based on the estimated value.

The first module 471 determines the weight value corresponding to at least one of the system identification information APP ID and the estimation condition. The first module 471 applies the determined weight value to a plurality of estimation results estimated by a plurality of SOX estimation models, and calculates an average value by adding up the plurality of estimation results to which the weight values are applied.

Table 1 below is an example of the plurality of first weight values corresponding to the system identification information APP ID. As described above, the first weight value may be the weight value considering only the system identification information APP ID, and as shown in Table 1 below, values corresponding to the estimation models may be different.

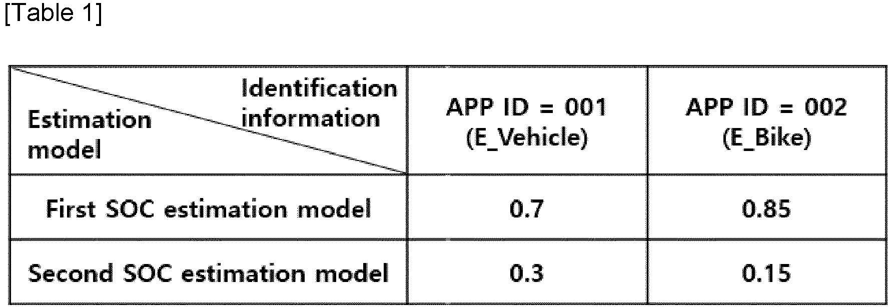

For example, it is assumed that the upper system 1 is the vehicle system (E_Vehicle and APP ID=001). Referring to FIG. 3 and Table 1, the first module 471 may apply the first weight value of 0.7 corresponding to a first SOC value (A1) estimated by the first SOC estimation model (A1 × 0.7), and may apply the first weight value of 0.3 corresponding to a second SOC value (A2) estimated by the second SOC estimation model (A2 × 0.3) so that the first module calculates an average value (Aave = (A1 × 0.7) + (A2 × 0.3)) of states of charge (SOC) of a first battery cell.

Specifically, when the first SOC value (A1) of the first battery cell estimated by the first SOC estimation model is 50 % and the second SOC value (A2) of the first battery cell estimated by the second SOC estimation model is 54 %, the first module 471 may calculate the average value (Aave) of the states of charge (SOC) of the first battery cell as 51.2 %. In the same way, the first module 471 may calculate an average value (Aave) of states of charge (SOC) of each of the plurality of battery cells such as a second battery cell, a third battery cell, or the like.

Table 2 below is an example of the plurality of second weight values corresponding to the system identification information APP ID and the estimation condition. As described above, the second weight value may be the weight value considering both system identification information APP ID and the estimation condition, and as shown in Table 2 below, values corresponding to the estimation models may be different.

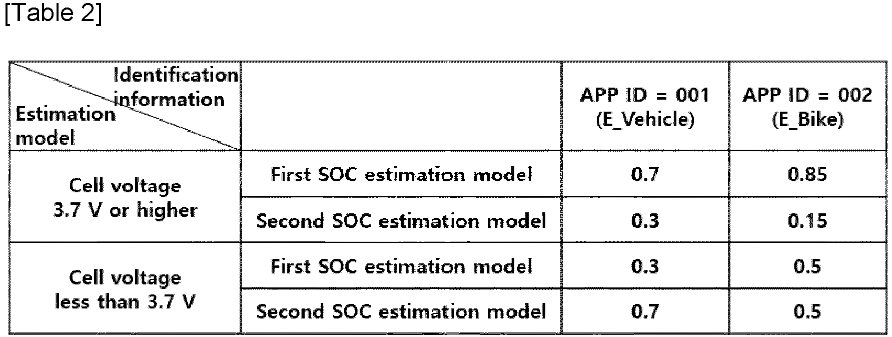

In Table 2, the estimated condition is described as a condition determined by a comparison result between the cell voltage and a predetermined reference value (e.g., 3.7 V), but as described above, the estimated condition is not limited to the cell voltage and the reference value.

For example, referring to Table 2, it is assumed that the upper system 1 is the vehicle system (E_Vehicle and APP ID=001) and the cell voltage of a first battery cell included in the current battery 10 is 3.7 V or higher. Referring to FIG. 3 and Table 2, the first module 471 may apply the second weight value of 0.7 corresponding to a first SOC value (A1) estimated by the first SOC estimation model (A1 × 0.7), and may apply the second weight value of 0.3 corresponding to a second SOC value (A2) estimated by the second SOC estimation model (A2 × 0.3) so that the first module calculates an average value (Aave = (A1 × 0.7) + (A2 × 0.3)) of states of charge (SOC) of the first battery cell.

Specifically, when the first SOC value (A1) of the first battery cell estimated by the first SOC estimation model is 50 % and the second SOC value (A2) of the first battery cell estimated by the second SOC estimation model is 54 %, the first module 471 may calculate the average value (Aave) of the states of charge (SOC) of the first battery cell as 51.2 %. In the same way, the first module 471 may calculate an average value (Aave) of states of charge (SOC) of each of the plurality of battery cells such as a second battery cell, a third battery cell, or the like.

For another example, referring to Table 2, it is assumed that the upper system 1 is the bike system (E_Bike and APP ID=002) and the cell voltage of a first battery cell included in the current battery 10 is less than 3.7 V. Referring to FIG. 3 and Table 2, the first module 471 may apply the second weight value of 0.5 corresponding to a first SOC value (A1) estimated by the first SOC estimation model (A1 × 0.5), and may apply the second weight value of 0.5 corresponding to a second SOC value (A2) estimated by the second SOC estimation model (A2 × 0.5) so that the first module calculates an average value (Aave = (A1 × 0.5) + (A2 × 0.5)) of states of charge (SOC) of the first battery cell.

Specifically, when the first SOC value (A1) of the first battery cell estimated by the first SOC estimation model is 50 % and the second SOC value (A2) of the first battery cell estimated by the second SOC estimation model is 54 %, the first module 471 may calculate the average value (Aave) of the states of charge (SOC) of the first battery cell as 52 %. In the same way, the first module 471 may calculate an average value (Aave) of states of charge (SOC) of each of the plurality of battery cells such as a second battery cell, a third battery cell, or the like.

In Tables 1 and 2, only the state of charge (SOC) of the battery 10 is described, but the present invention is not limited thereto. In the same manner as described above, the first module 471 may use the plurality of SOH estimation models and the plurality of SOP estimation models shown in FIG. 3 to calculate an average value (Bave) of states of health (SOH) for each of the plurality of battery cells and an average value (Cave) of states of power (SOP) for each of the plurality of battery cells.

The second module 473 may determine an average value of battery states (SOX) calculated by the first module 471 as a battery state (SOX) value, and may perform failure diagnosis or the like for the battery 10 based on the battery state (SOX) value. For example, the second module 473 may diagnose the battery 10 as in a failure state when the average value (Bave) of the states of health (SOH) is smaller than a preset reference value.

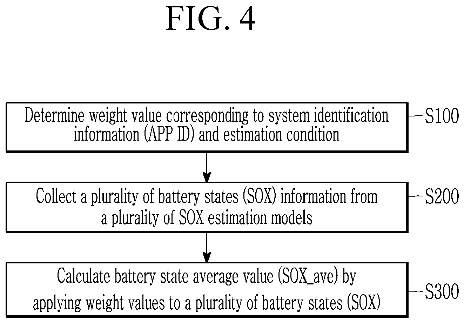

FIG. 4 is a flowchart illustrating a battery state estimation method according to an embodiment.

Hereinafter, the battery state estimation method and a battery system providing the method will be described with reference to FIGS. 1 to 4.

Referring to FIG. 4, the BMS 40 determines the weight value corresponding to the identification information APP ID of the upper system 1 at which the battery system 2 is mounted and the predetermined estimation condition (S100).

The BMS 40 may first determine the first weight value or the second weight value based on the battery state (SOX) to be estimated, the system identification information APP ID, and whether the estimation condition is applied.

According to an embodiment, when the battery state (SOX) is estimated by considering only the identification information APP ID of the upper system 1 at which the battery system 2 is mounted, the BMS 40 may determine the first weight value in Table 1 previously stored in the storage device 43.

For example, when the state of charge (SOC) of each of the plurality of battery cells mounted on the vehicle system (E_Vehicle and APP ID = 001) is estimated, the BMS 40 may determine the first weight value (0.7) to be applied to the first SOC value (A1) estimated by the first SOC estimation model and the first weight value (0.3) corresponding to the second SOC value (A2) estimated by the second SOC estimation model.

According to another embodiment, when the battery state (SOX) in consideration of the identification information APP ID of the upper system 1 on which the battery system 2 is mounted and the estimation condition is estimated, the BMS 40 may determine the second weight value in Table 2 previously stored in the storage device 43.

For example, when the state of charge (SOC) of each of the plurality of battery cells mounted on the bike system (E_Bike and APP ID=002) is estimated under a condition that the cell voltage is less than 3.7 V, the BMS 40 may determine the second weight value (0.5) to be applied to the first SOC value (A1) estimated by the first SOC estimation model and the second weight value (0.5) corresponding to the second SOC value (A2) estimated by the second SOC estimation model.

Next, the BMS 40 collects information on the battery state (SOX) of each of the plurality of battery cells from each of the plurality of SOX estimation models for estimating the battery state (SOX) based on the battery information according to a predetermined algorithm (S200).

Referring to FIG. 3, for example, the BMS 40 may collect information on the first SOC value (A1) estimated by the first SOC estimation model and information on the second SOC value (A2) estimated by the second SOC estimation module. For another example, the BMS 40 may collect information on a first SOH value (B1) estimated by the first SOH estimation model and information on a second SOH value (B2) estimated by the second SOH estimation model. For another example, the BMS 40 may collect information on a first SOP value (C1) estimated by the first SOP estimation model and information on a second SOP value (C2) estimated by the second SOP estimation model.

Next, the BMS 40 calculates the average value of the battery states (SOX) by summing (or adding up) results of applying the weight value to each of a plurality of battery states (SOX) (S300).

For example, it is assumed that the upper system 1 is the bike system (E_Bike and APP ID=002) and the cell voltage of a first battery cell included in the current battery 10 is less than 3.7 V. Referring to FIG. 3 and Table 2, the BMS 40 may apply the second weight value of 0.5 corresponding to a first SOC value (A1) estimated by the first SOC estimation model (A1 × 0.5), and may apply the second weight value of 0.5 corresponding to a second SOC value (A2) estimated by the second SOC estimation model (A2 × 0.5) so that the BMS calculates an average value (Aave = (A1 × 0.5) + (A2 × 0.5)) of states of charge (SOC) of the first battery cell. Specifically, when the first SOC value (A1) is 50 % and the second SOC value (A2) is 54 %, the BMS 40 may calculate the average value (Aave) of the states of charge (SOC) of the first battery cell as 52 %.

Thereafter, based on the calculated average value of the battery states (SOX), the BMS 40 may diagnose a failure state of the battery and may determine whether to perform cell balancing and the like.

In summary, an estimation model that accurately estimates the state of charge (SOC), the state of health (SOH), the state of power (SOP), and the like of the battery 10 may differ depending on an environment in which the battery 10 is used, that is, the upper system 1 and the current state (e.g., the cell voltage, the cell temperature, or the like) of the battery. The present invention may use the plurality of estimation models so that it estimates a current state (SOX) of the battery 10 with higher precision by applying the weight value reflecting a situation as described above to a result estimated by the plurality of estimation models.

While this invention has been described in connection with what is presently considered to be practical embodiments, it is to be understood that the invention is not limited to the disclosed embodiments, but, on the contrary, is intended to cover various modifications and equivalent arrangements included within the scope of the appended claims.

## Claims

1. A battery system (2) comprising:
a battery (10) including a plurality of battery cells;
a communication device (45) configured to communicate with an upper system (1) on which the battery system is mounted, and receives identification information of the upper system, wherein the identification information of the upper system identifies the upper system at which the battery system is mounted;
a monitoring device (41) configured to collect at least one of battery information including a plurality of cell voltages of the plurality of battery cells, a current of the battery, and a temperature of the battery;
a storage device (43) configured to store a plurality of state of charge, SOC, estimation models estimating an SOC of each of the plurality of battery cells based on the battery information according to a predetermined algorithm, and store a previously set plurality of first weight values corresponding to the identification information of variety of upper systems; and
a controller (47) configured to determine first weight values from the stored plurality of first weight values based on the received identification information of the upper system, and calculate an average value of first SOCs by adding up results of applying the determined first weight values to a plurality of SOCs estimated by the plurality of SOC estimation models.

2. The battery system of claim 1, wherein the storage device is configured to store a previously set plurality of second weight values corresponding to the identification information of variety of upper systems, wherein the controller is configured to determine second weight values from the plurality of second weight values based on the received identification information of the upper system, and calculate an average value of second SOCs by adding up results of applying the determined second weight values and a predetermined estimation condition, to the plurality of SOCs.

3. The battery system of claim 2, wherein the estimation condition is determined according to a result of comparing each of the cell voltages with a predetermined reference value.

4. The battery system of claim 3, wherein the storage device is configured to store a plurality of pieces of identification information of the upper system on which the battery system is mounted, the first weight values corresponding to each of the plurality of pieces of identification information, and the second weight values corresponding to each of the plurality of pieces of identification information.

5. A battery system (2) comprising:
a battery (10) including a plurality of battery cells;
a communication device (45) configured to communicate with an upper system (1) on which the battery system is mounted, and receives identification information of the upper system, wherein the identification information of the upper system identifies the upper system at which the battery system is mounted;
a monitoring device (41) configured to collect at least one of battery information including a plurality of cell voltages of the plurality of battery cells, a current of the battery, and a temperature of the battery;
a storage device (43) configured to store a plurality of state of health, SOH, estimation models estimating an SOH of each of the plurality of battery cells based on the battery information according to a predetermined algorithm, and store a previously set plurality of first weight values corresponding to the identification information of variety of upper systems; and
a controller (47) configured to determine first weight values from the stored plurality of first weight values based on the received identification information of the upper system, and calculate an average value of first SOHs by adding up results of applying the determined first weight values to a plurality of SOHs estimated by the plurality of SOH estimation models.

6. The battery system of claim 5, wherein the storage device is configured to store a previously set plurality of second weight values corresponding to the identification information of variety of upper systems, wherein the controller is configured to determine second weight values from the plurality of second weight values based on the received identification information of the upper system, and calculate an average value of second SOHs by adding up results of applying the determined second weight values and a predetermined estimation condition, to the plurality of SOHs.

7. The battery system of claim 6, wherein the estimation condition is determined according to a result of comparing each of the cell voltages with a predetermined reference value.

8. The battery system of claim 7, wherein the storage device is configured to store a plurality of pieces of identification information of the upper system on which the battery system is mounted, the first weight values corresponding to each of the plurality of pieces of identification information, and the second weight values corresponding to each of the plurality of pieces of identification information.

9. A battery state estimation method comprising:
determining first weight values from a previously set plurality of first weight values based on identification information of an upper system (1) on which a battery system (2) is mounted, wherein the previously set plurality of first weight values corresponds to the identification information of variety of upper systems;
receiving a plurality of states of charge, SOC, from a plurality of state of charge ,SOC, estimation models estimating an SOC of each of the plurality of battery cells included in a battery based on battery information according to a predetermined algorithm; and
calculating an average value of first SOCs by adding up results of applying the determined first weight values to the plurality of SOCs,
wherein the battery information includes at least one of a plurality of cell voltages of the plurality of battery cells, a current of the battery, and a temperature of the battery.

10. The battery state estimation method of claim 9, wherein the determining of the first weight values comprises determining second weight values from a previously set plurality of second weight values based on the identification information and a predetermined estimation condition, and
wherein the calculating of the average value comprises calculating an average value of second SOCs by adding up results of applying the determined second weight values to the plurality of SOCs.

11. The battery state estimation method of claim 10, wherein the estimation condition is determined according to a result of comparing each of the cell voltages with a predetermined reference value.

## Patentansprüche

1. Batteriesystem (2), umfassend:
eine Batterie (10), welche eine Mehrzahl von Batteriezellen umfasst;
eine Kommunikationsvorrichtung (45), welche dazu eingerichtet ist, mit einem höheren System (1) zu kommunizieren, an welchem das Batteriesystem montiert ist, und welche eine Identifikationsinformation des höheren Systems empfängt, wobei die Identifikationsinformation des höheren Systems das höhere System identifiziert, an welchem das Batteriesystem montiert ist;
eine Überwachungsvorrichtung (41), welche dazu eingerichtet ist, wenigstens eines aus einer Batterieinformation zu sammeln, welche eine Mehrzahl von Zellenspannungen der Mehrzahl von Batteriezellen, einen Strom der Batterie und eine Temperatur der Batterie umfasst;
eine Speichervorrichtung (43), welche dazu eingerichtet ist, eine Mehrzahl von Ladezustand-, SOC,-Schätzmodellen zu speichern, welche einen SOC jeder der Mehrzahl von Batteriezellen auf Grundlage der Batterieinformation gemäß einem vorbestimmten Algorithmus schätzen, und eine zuvor festgelegte Mehrzahl erster Gewichtungswerte zu speichern, welche der Identifikationsinformation einer Vielfalt höherer Systeme entsprechen; und
eine Steuereinheit (47), welche dazu eingerichtet ist, auf Grundlage der empfangenen Identifikationsinformation des höheren Systems erste Gewichtungswerte aus der gespeicherten Mehrzahl erster Gewichtungswerte zu bestimmen und einen Durchschnittswert erster SOC durch Addieren der Ergebnisse eines Anwendens der bestimmten ersten Gewichtungswerte mit einer Mehrzahl von SOC zu berechnen, welche durch die Mehrzahl der SOC-Schätzmodelle geschätzt worden sind.

2. Batteriesystem nach Anspruch 1, wobei die Speichervorrichtung dazu eingerichtet ist, eine zuvor festgelegte Mehrzahl zweiter Gewichtungswerte zu speichern, welche der Identifikationsinformation einer Vielfalt höhere Systeme entsprechen, wobei die Steuereinheit dazu eingerichtet ist, zweite Gewichtungswerte aus der Mehrzahl zweiter Gewichtungswerte auf Grundlage der empfangenen Identifikationsinformation des höheren Systems zu bestimmen und einen Durchschnittswert zweiter SOC durch Addieren der Ergebnisse eines Anwendens der bestimmten zweiten Gewichtungswerte und einer vorbestimmten Schätzbedingung mit der Mehrzahl von SOC zu berechnen.

3. Batteriesystem nach Anspruch 2, wobei die Schätzbedingung gemäß einem Ergebnis eines Vergleichens jeder der Zellenspannungen mit einem vorbestimmten Referenzwert bestimmt wird.

4. Batteriesystem nach Anspruch 3, wobei die Speichervorrichtung dazu eingerichtet ist, eine Mehrzahl von Identifikationsinformationen des höheren Systems, an welchem das Batteriesystem montiert ist, die ersten Gewichtungswerte, welche jeder der Mehrzahl von Identifikationsinformationen entsprechen, und die zweiten Gewichtungswerte zu speichern, welche jeder der Mehrzahl von Identifikationsinformationen entsprechen.

5. Batteriesystem (2), umfassend:
eine Batterie (10), welche eine Mehrzahl von Batteriezellen umfasst;
eine Kommunikationsvorrichtung (45), welche dazu eingerichtet ist, mit einem höheren System (1) zu kommunizieren, an welchem das Batteriesystem montiert ist, und welche eine Identifikationsinformation des höheren Systems empfängt, wobei die Identifikationsinformation des höheren Systems das höhere System identifiziert, an welchem das Batteriesystem montiert ist;
eine Überwachungsvorrichtung (41), welche dazu eingerichtet ist, wenigstens eines aus einer Batterieinformation zu sammeln, welche eine Mehrzahl von Zellenspannungen der Mehrzahl von Batteriezellen, einen Strom der Batterie und eine Temperatur der Batterie umfasst;
eine Speichervorrichtung (43), welche dazu eingerichtet ist, eine Mehrzahl von Gesundheitszustand-, SOH,-Schätzmodellen zu speichern, welche einen SOH jeder der Mehrzahl von Batteriezellen auf Grundlage der Batterieinformation gemäß einem vorbestimmten Algorithmus schätzen, und eine zuvor festgelegte Mehrzahl erster Gewichtungswerte zu speichern, welche der Identifikationsinformation einer Vielfalt höherer Systeme entsprechen; und
eine Steuereinheit (47), welche dazu eingerichtet ist, auf Grundlage der empfangenen Identifikationsinformation des höheren Systems erste Gewichtungswerte aus der gespeicherten Mehrzahl erster Gewichtungswerte zu bestimmen und einen Durchschnittswert erster SOH durch Addieren der Ergebnisse eines Anwendens der bestimmten ersten Gewichtungswerte mit einer Mehrzahl von SOH zu berechnen, welche durch die Mehrzahl der SOH-Schätzmodelle geschätzt worden sind.

6. Batteriesystem nach Anspruch 5, wobei die Speichervorrichtung dazu eingerichtet ist, eine zuvor festgelegte Mehrzahl zweiter Gewichtungswerte zu speichern, welche der Identifikationsinformation einer Vielfalt höhere Systeme entsprechen, wobei die Steuereinheit dazu eingerichtet ist, zweite Gewichtungswerte aus der Mehrzahl zweiter Gewichtungswerte auf Grundlage der empfangenen Identifikationsinformation des höheren Systems zu bestimmen und einen Durchschnittswert zweiter SOC durch Addieren der Ergebnisse eines Anwendens der bestimmten zweiten Gewichtungswerte und einer vorbestimmten Schätzbedingung mit der Mehrzahl von SOH zu berechnen.

7. Batteriesystem nach Anspruch 6, wobei die Schätzbedingung gemäß einem Ergebnis eines Vergleichens jeder der Zellenspannungen mit einem vorbestimmten Referenzwert bestimmt wird.

8. Batteriesystem nach Anspruch 7, wobei die Speichervorrichtung dazu eingerichtet ist, eine Mehrzahl von Identifikationsinformationen des höheren Systems, an welchem das Batteriesystem montiert ist, die ersten Gewichtungswerte, welche jeder der Mehrzahl von Identifikationsinformationen entsprechen, und die zweiten Gewichtungswerte zu speichern, welche jeder der Mehrzahl von Identifikationsinformationen entsprechen.

9. Batteriezustand-Schätzverfahren, umfassend:
Bestimmen erster Gewichtungswerte aus einer zuvor festgelegten Mehrzahl erster Gewichtungswerte auf Grundlage einer Identifikationsinformation eines höheren Systems (1), an welchem ein Batteriesystem (2) montiert ist, wobei die zuvor festgelegte Mehrzahl erster Gewichtungswerte der Identifikationsinformation einer Vielfalt höherer Systeme entspricht;
Empfangen einer Mehrzahl von Ladezuständen, SOC, aus einer Mehrzahl von Ladezustand-, SOC,-Schätzmodellen, welche auf Grundlage einer Batterieinformation gemäß einem vorbestimmten Algorithmus einen SOC jeder der Mehrzahl von Batteriezellen schätzen, welche in einer Batterie umfasst sind; und
Berechnen eines Durchschnittswerts erster SOC durch Addieren der Ergebnisse eines Anwendens der bestimmten ersten Gewichtungswerte mit der Mehrzahl von SOC,
wobei die Batterieinformation wenigstens eines umfasst aus einer Mehrzahl von Zellenspannungen der Mehrzahl von Batteriezellen, einem Strom der Batterie und einer Temperatur der Batterie.

10. Batteriezustand-Schätzverfahren nach Anspruch 9, wobei das Bestimmen der ersten Gewichtungswerte ein Bestimmen zweiter Gewichtungswerte aus einer zuvor festgelegten Mehrzahl zweiter Gewichtungswerte auf Grundlage der Identifikationsinformation und einer vorbestimmten Schätzbedingung umfasst, und
wobei das Berechnen des Durchschnittswerts ein Berechnen eines Durchschnittswerts zweiter SOC durch Addieren der Ergebnisse eines Anwendens der bestimmten zweiten Gewichtungswerte mit der Mehrzahl von SOC umfasst.

11. Batteriezustand-Schätzverfahren nach Anspruch 10, wobei die Schätzbedingung gemäß einem Ergebnis eines Vergleichens jeder der Zellenspannungen mit einem vorbestimmten Referenzwert bestimmt wird.

## Revendications

1. Système de batterie (2), comprenant :
une batterie (10) incluant une pluralité d'éléments de batterie ;
un dispositif de communication (45) configuré pour communiquer avec un système supérieur (1) sur lequel est monté le système de batterie, et qui reçoit des informations d'identification du système supérieur, dans lequel les informations d'identification du système supérieur identifient le système supérieur sur lequel est monté le système de batterie ;
un dispositif de surveillance (41) configuré pour collecter au moins un élément parmi des informations de batterie incluant une pluralité de tensions d'éléments de la pluralité d'éléments de batterie, un courant de la batterie et une température de la batterie ;
un dispositif de stockage (43) configuré pour stocker une pluralité de modèles d'estimation d'état de charge, SOC, estimant un SOC de chacun de la pluralité d'éléments de batterie en fonction des informations de batterie selon un algorithme prédéterminé, et stocker une pluralité précédemment définie de premières valeurs de poids correspondant aux informations d'identification d'une multitude de systèmes supérieurs ; et
un contrôleur (47) configuré pour déterminer des premières valeurs de poids à partir de la pluralité stockée de premières valeurs de poids en fonction des informations d'identification du système supérieur reçues, et calculer une valeur moyenne de premiers SOC en additionnant les résultats de l'application des premières valeurs de poids déterminées à une pluralité de SOC estimés par la pluralité de modèles d'estimation de SOC.

2. Système de batterie selon la revendication 1, dans lequel le dispositif de stockage est configuré pour stocker une pluralité précédemment définie de secondes valeurs de poids correspondant aux informations d'identification d'une multitude de systèmes supérieurs, dans lequel le contrôleur est configuré pour déterminer des secondes valeurs de poids à partir de la pluralité de secondes valeurs de poids en fonction des informations d'identification du système supérieur reçues, et calculer une valeur moyenne de seconds SOC en additionnant les résultats de l'application des secondes valeurs de poids déterminées et d'une condition d'estimation prédéterminée, à la pluralité de SOC.

3. Système de batterie selon la revendication 2, dans lequel la condition d'estimation est déterminée en fonction d'un résultat de la comparaison de chacune des tensions d'éléments à une valeur de référence prédéterminée.

4. Système de batterie selon la revendication 3, dans lequel le dispositif de stockage est configuré pour stocker une pluralité d'informations d'identification du système supérieur sur lequel est monté le système de batterie, les premières valeurs de poids correspondant à chacune de la pluralité d'informations d'identification, et les secondes valeurs de poids correspondant à chacune de la pluralité d'informations d'identification.

5. Système de batterie (2), comprenant :
une batterie (10) incluant une pluralité d'éléments de batterie ;
un dispositif de communication (45) configuré pour communiquer avec un système supérieur (1) sur lequel est monté le système de batterie, et qui reçoit des informations d'identification du système supérieur, dans lequel les informations d'identification du système supérieur identifient le système supérieur sur lequel est monté le système de batterie ;
un dispositif de surveillance (41) configuré pour collecter au moins un élément parmi des informations de batterie incluant une pluralité de tensions d'éléments de la pluralité d'éléments de batterie, un courant de la batterie et une température de la batterie ;
un dispositif de stockage (43) configuré pour stocker une pluralité de modèles d'estimation d'état de santé, SOH, estimant un SOH de chacun de la pluralité d'éléments de batterie en fonction des informations de batterie selon un algorithme prédéterminé, et stocker une pluralité précédemment définie de premières valeurs de poids correspondant aux informations d'identification d'une multitude de systèmes supérieurs ; et
un contrôleur (47) configuré pour déterminer des premières valeurs de poids à partir de la pluralité stockée de premières valeurs de poids en fonction des informations d'identification du système supérieur reçues, et calculer une valeur moyenne de premiers SOH en additionnant les résultats de l'application des premières valeurs de poids déterminées à une pluralité de SOH estimés par la pluralité de modèles d'estimation de SOH.

6. Système de batterie selon la revendication 5, dans lequel le dispositif de stockage est configuré pour stocker une pluralité précédemment définie de secondes valeurs de poids correspondant aux informations d'identification d'une multitude de systèmes supérieurs, dans lequel le contrôleur est configuré pour déterminer des secondes valeurs de poids à partir de la pluralité de secondes valeurs de poids en fonction des informations d'identification du système supérieur reçues, et calculer une valeur moyenne de seconds SOH en additionnant les résultats de l'application des secondes valeurs de poids déterminées et d'une condition d'estimation prédéterminée, à la pluralité de SOH.

7. Système de batterie selon la revendication 6, dans lequel la condition d'estimation est déterminée en fonction d'un résultat de la comparaison de chacune des tensions d'éléments à une valeur de référence prédéterminée.

8. Système de batterie selon la revendication 7, dans lequel le dispositif de stockage est configuré pour stocker une pluralité d'informations d'identification du système supérieur sur lequel est monté le système de batterie, les premières valeurs de poids correspondant à chacune de la pluralité d'informations d'identification, et les secondes valeurs de poids correspondant à chacune de la pluralité d'informations d'identification.

9. Procédé d'estimation d'état de batterie, comprenant :
la détermination de premières valeurs de poids à partir d'une pluralité précédemment définie de premières valeurs de poids sur la base d'informations d'identification d'un système supérieur (1) sur lequel est monté un système de batterie (2), dans lequel la pluralité précédemment définie de premières valeurs de poids correspondent aux informations d'identification d'une multitude de systèmes supérieurs ;
la réception d'une pluralité d'états de charge, SOC, provenant d'une pluralité de modèles d'estimation d'état de charge, SOC, estimant un SOC de chacun de la pluralité d'éléments de batterie inclus dans une batterie, sur la base d'informations de batterie, selon un algorithme prédéterminé ; et
le calcul d'une valeur moyenne de premiers SOC en additionnant les résultats de l'application des premières valeurs de poids déterminées à la pluralité de SOC,
dans lequel les informations de batterie incluent au moins un parmi une pluralité de tensions d'éléments de la pluralité d'éléments de batterie, un courant de la batterie et une température de la batterie.

10. Procédé d'estimation d'état de batterie selon la revendication 9, dans lequel la détermination des premières valeurs de poids comprend la détermination de secondes valeurs de poids à partir d'une pluralité précédemment définie de secondes valeurs de poids, sur la base des informations d'identification et d'une condition d'estimation prédéterminée, et
dans lequel le calcul de la valeur moyenne comprend le calcul d'une valeur moyenne de seconds SOC en additionnant les résultats de l'application des secondes valeurs de poids déterminées à la pluralité de SOC.

11. Procédé d'estimation d'état de batterie selon la revendication 10, dans lequel la condition d'estimation est déterminée en fonction d'un résultat de la comparaison de chacune des tensions d'éléments à une valeur de référence prédéterminée.
